(19) **Europäisches Patentamt / European Patent Office / Office européen des brevets**

(11) **EP 3 084 477 B1**

(12) **EUROPEAN PATENT SPECIFICATION**

(45) Date of publication and mention of the grant of the patent:
**20.05.2020 Bulletin 2020/21**

(51) Int Cl.:
*G01T 1/20* *(2006.01)*     *G01T 1/24* *(2006.01)*
*H01L 27/146* *(2006.01)*

(21) Application number: **14823956.9**

(86) International application number:
**PCT/EP2014/078050**

(22) Date of filing: **16.12.2014**

(87) International publication number:
**WO 2015/091540 (25.06.2015 Gazette 2015/25)**

(54) **RADIOGRAPHY FLAT PANEL DETECTOR HAVING A LOW WEIGHT X-RAY SHIELD AND THE METHOD OF PRODUCTION THEREOF**

FLACHER RÖNTGENDETEKTOR MIT LEICHTGEWICHTIGEM RÖNTGENSCHIRM UND VERFAHREN ZUR HERSTELLUNG DAVON

DÉTECTEUR DE PANNEAU PLAT DE RADIOGRAPHIE POSSÉDANT UN ÉCRAN AUX RAYONS X DE FAIBLE POIDS ET SON PROCÉDÉ DE PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.12.2013 EP 13197734**

(43) Date of publication of application:
**26.10.2016 Bulletin 2016/43**

(73) Proprietor: **AGFA NV**
**2640 Mortsel (BE)**

(72) Inventors:
• **LEBLANS, Paul**
  **2640 Mortsel (BE)**
• **VANDENBROUCKE, Dirk**
  **2640 Mortsel (BE)**
• **TAHON, Jean-Pierre**
  **2640 Mortsel (BE)**
• **ELEN, Sabina**
  **2640 Mortsel (BE)**

(74) Representative: **Verbrugghe, Anne Marie L.**
**Agfa HealthCare NV**
**IP Department 3802**
**Septestraat 27**
**2640 Mortsel (BE)**

(56) References cited:
EP-A1- 1 624 320     EP-A2- 1 770 718
WO-A1-2005/057235     US-A1- 2006 065 846
US-A1- 2008 011 960

## Description

### Technical Field

The present invention relates to diagnostic imaging and more particularly, to a radiography X-ray detector having an X-ray shield which protects the detector electronics and reduces or eliminates the impact of backscattered X-rays during the exposure of the subject to the X-ray source.

### Background Art

X-ray imaging is a non-invasive technique to capture medical images of patients or animals as well as to inspect the contents of sealed containers, such as luggage, packages, and other parcels. To capture these images, an X-ray beam irradiates an object. The X-rays are then attenuated as they pass through the object. The degree of attenuation varies across the object as a result of variances in the internal composition and/or thickness of the object. The attenuated X-ray beam impinges upon an X-ray detector designed to convert the attenuated beam to a usable shadow image of the internal structure of the object.

Increasingly, radiography flat panel detectors (RFPDs) are being used to capture images of objects during inspection procedures or of body parts of patients to be analyzed. These detectors can convert the X-rays directly into electric charges (direct conversion direct radiography - DCDR), or in an indirect way (indirect conversion direct radiography - ICDR).

In direct conversion direct radiography, the RFPDs convert X-rays directly into electric charges. The X-rays are directly interacting with a photoconductive layer such as amorphous selenium (a-Se).

In indirect conversion direct radiography, the RFPDs have a scintillating phosphor such as Csl:TI or $Gd_2O_2S$ which converts X-rays into light which then interacts with an amorphous silicon (a-Si) semiconductor layer, where electric charges are created.

The created electric charges are collected via a switching array, comprising thin film transistors (TFTs). The transistors are switched-on row by row and column by column to read out the signal of the detector. The charges are transformed into voltage, which is converted in a digital number that is stored in a computer file which can be used to generate a softcopy or hardcopy image. Recently Complementary Metal Oxides Semiconductors (CMOS) sensors are becoming important in X-ray imaging. The detectors based on CMOS are already used in mammography, dental, fluoroscopy, cardiology and angiography images. The advantage of using those detectors is a high readout speed and a low electronic noise.

Generally, the imaging array including TFTs as switching array and photodiodes (in case of ICDR) is deposited on a thin substrate of glass. The assembly of scintillator or photoconductor and the imaging array on the glass substrate does not absorb all primary radiation, coming from the X-ray source and transmitted by the object of the diagnosis. Hence the electronics positioned under this assembly are exposed to a certain fraction of the primary X-ray radiation. Since the electronics are not sufficiently radiation hard, this transmitted radiation may cause damage.

Moreover, X-rays which are not absorbed by the assembly of scintillator or photoconductor and the imaging array on the glass substrate, can be absorbed in the structures underneath the glass substrate. The primary radiation absorbed in these structures generates secondary radiation that is emitted isotropically and that thus exposes the imaging part of the detector. The secondary radiation is called "backscatter" and can expose the image part image of the detector, thereby introducing artefacts into the reconstructed image. Since the space under the assembly is not homogeneously filled, the amount of scattered radiation is position dependent. Part of the scattered radiation is emitted in the direction of the assembly of scintillator or photoconductor and imaging array and may contribute to the recorded signal. Since this contribution is not spatially homogeneous this contribution will lead to haze in the image, and, therefore, reduce the dynamic range. It will also create image artefacts.

To avoid damage to the electronics and image artefacts due to scattered radiation, an X-ray shield may be applied underneath the assembly of scintillator or photoconductor and imaging array. Because of their high density and high intrinsic stopping power for X-rays, metals with a high atomic number are used as materials in such an X-ray shield. Examples of these are sheets or plates from tantalum, lead or tungsten as disclosed in EP1471384B1, US2013/0032724A1 and US2012/0097857A1.

However, metals with a high atomic number also have a high density. Hence, X-ray shields based on these materials have a high weight. Weight is an important characteristic of the RFPD especially for the portability of the RFPDs. Any weight reduction is, therefore, beneficial for the users of the RFPDs such as medical staff.

US7317190B2 discloses a radiation absorbing X-ray detector panel support comprising a radiation absorbing material to reduce the reflection of X-rays of the back cover of the X-ray detector. The absorbing material containing heavy atoms such as lead, barium sulphate and tungsten can be disposed as a film via a chemical vapour deposition technique onto a rigid panel support or can be mixed via injection moulding with the base materials used to fabricate the rigid panel support.

In US5650626, an X-ray imaging detector is disclosed which contains a substrate, supporting the conversion and detection unit. The substrate includes one or more elements having atomic numbers greater than 22. Since the detection array is directly deposited on the substrate, the variety of suitable materials of the substrate is rather limited.

In US5777335, an imaging device is disclosed comprising a substrate, preferably glass containing a metal selected from a group formed by Pb, Ba, Ta or W. According to the inventors, the use of this glass would not require an additional X-ray shield based on lead. However, glass containing sufficient amounts of metals from a group formed by Pb, Ba, Ta or W is more expensive than glass which is normally used as a substrate for imaging arrays.

US7569832 discloses a radiographic imaging device, namely a RFPD, comprising two scintillating phosphor layers as scintillators each one having different thicknesses and a transparent substrate to the X-rays between said two layers. The use of an additional phosphor layer at the opposite side of the substrate improves the X-ray absorption while maintaining the spatial resolution. The presence of the additional phosphor layer as disclosed is not sufficient to absorb all primary X-ray radiation to prevent damage of the underlying electronics and to prevent backscatter. An extra X-ray shield will still be required in the design of this RFPD.

In US2008/011960A1 a dual-screen digital radiography apparatus is claimed. This apparatus consists of two flat panel detectors (front panel and back panel) each comprising a scintillating phosphor layer to capture and process X-rays. The scintillating phosphor layer in the back panel contributes to the image formation and has no function as X-ray shield to protect the underlying electronics. This dual-screen digital flat panel, still requires an X-ray shield to protect the underlying electronics and to avoid image artefacts due to scattered radiation.

WO2005057235A1 describes a shielding for an X-ray detector wherein lead or another suitable material is disposed in front of the processing circuits in a CT-device.

WO20051055938 discloses a light weight film, with an X-ray absorption at least equivalent to 0.254 mm of lead and which has to be applied on garments or fabrics for personal radiation protection or attenuation, such as aprons, thyroid shields, gonad shields, gloves, etc. Said film is obtained from a polymer latex mixture comprising high atomic weight metals or their related compounds and/or alloys. The suitable metals are the ones that have an atomic number greater than 45. No use of this light weight film in a RFPD is mentioned. Although a light weight film is claimed, the metal particles used in the composition of the film still contribute to a high extend to the weight of the shield.

US6548570 discloses a radiation shielding composition to be applied on garments or fabrics for personal radiation protection. The composition comprised a polymer, preferably an elastomer, and a homogeneously dispersed powder of a metal with high atomic number in an amount of at least 80% in weight of the composition as filler. A loading material is mixed with the filler material and kneaded with the elastomer at a temperature below 180°C resulting in a radiation shielding composition that can be applied homogeneously to garments and fabrics on an industrial scale. The use of metals is however increasing the weight of the shield of this invention considerably.

WO2009/0078891 discloses a radiation shielding sheet which is free from lead and other harmful components having a highly radiation shielding performance and an excellent economical efficiency. Said sheet is formed by filling a shielding material into an organic polymer material, the shielding material being an oxide powder containing at least one element selected from the group consisting of lanthanum (La), cerium (Ce), praseodymium (Pr), neodymium (Nd), samarium (Sm), europium (Eu) and gadolinium (Gd) and the polymer being a material such as rubber, thermoplastic elastomer, polymer resin or similar. The volumetric amount of the shielding material filled in the radiation shielding sheet is 40 to 80 vol. % with respect to the total volume of the sheet. No use of this light weight film in a RFPD is mentioned.

From the foregoing discussion, it should be apparent that there is a need for a RFPD with an X-ray shield to protect the underlying electronics and to absorb the scattered radiation produced by the underlying structures to avoid image artefacts in the imaging area, but which has a low weight, a low cost and which can be produced in an economically efficient way.

**Summary of invention**

It is therefore an object of the present invention to provide a solution for the high weight contribution of the X-ray shield in a radiography flat panel detector having a single imaging array and to provide at the same time a solution for producing the X-ray shield on an economically efficient way. The object has been achieved by a method of making a radiography flat panel detector as defined in claim 1. The X-ray shield is the combination of the 2$^{nd}$ substrate and the X-ray absorbing layer as defined in claim 1.

An additional advantage of the RFPD as defined in claim 1, is that the thickness of said X-ray shield can be adjusted in a continuous way to the required degree of the X-ray shielding effect instead of in large steps as it is in the case of shielding metal sheets commercially available with standard thicknesses. Even though plates with custom made thickness can be purchased, the price of those metal plates is still very high because of the customization.

In accordance with the present invention, the composition of the X-ray shield leads to an X-ray absorbing layer which is mechanically strong enough to avoid sealing the layer with a second substrate or which do not require expensive moulding techniques. Moreover, the X-ray shield comprises a second substrate, the X-ray shield contributes thus to the mechanical strength of the whole RFPD and more specifically of the thin fragile glass substrate of the single imaging array.

According to the present invention, the method includes providing a substrate and coating on said substrate a binder with at least one chemical compound having a metal element with an atomic number of 20 or more and one or more non-metal elements.

Other features, elements, steps, characteristics and advantages of the present invention will become more apparent from the following detailed description of preferred embodiments of the present invention. Specific embodiments of the invention are also defined in the dependent claim.

## Brief description of drawings

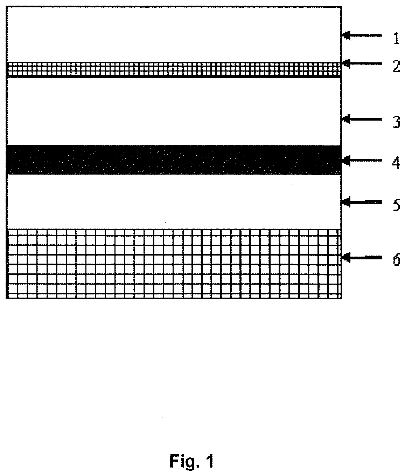

Fig. 1 represents a cross-section of a RFPD and the underlying electronics, wherein:

1 is the scintillator or photoconductive layer
2 is the single imaging array
3 is the first substrate
4 is the second substrate
5 is the X-ray absorbing layer
6 is the underlying electronics

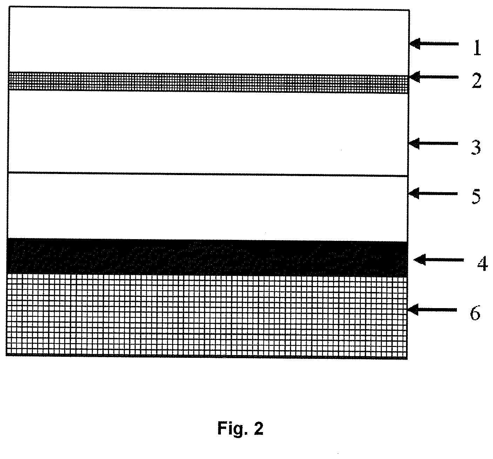

Fig. 2 represents a cross-section of a RFPD, wherein:

1 is the scintillator or photoconductive layer
2 is the single imaging array
3 is the first substrate
4 is the second substrate
5 is the X-ray absorbing layer
6 is the underlying electronics

## Description of embodiments

The present invention relates to a method of making a radiography flat panel detector (RFPD) comprising a scintillator, a single imaging array on a first substrate and an X-ray shield having an X-ray absorbing layer comprising a binder and a chemical compound having a metal element with an atomic number of 20 or more and one or more non-metal elements coated on a substrate ($2^{nd}$ substrate).

## X-ray absorbing layer

It has been found that X-ray shields can be made with the same X-ray stopping power but with considerably less weight than X-ray shields consisting of metals only by use of a layer comprising a binder and one or more chemical compounds having a metal element with an atomic number of 20 or more and one or more non-metal elements. Preferably these compounds are oxides or salts such as halides, oxysulphides, sulphites, carbonates of metals with an atomic number of 20 or higher. Examples of suitable metal elements with an atomic number higher than 20 that can be used in the scope of the present invention are metals such as Barium (Ba), Calcium (Ca), Cerium (Ce), Caesium (Cs), Gadolinium (Gd), Lanthanum (La), Lutetium (Lu), Palladium (Pd), Tin (Sn), Strontium (Sr), Tellurium (Te), Yttrium (Y), and Zinc (Zn). A further advantage of the invention is that these compounds are relatively inexpensive and are characterised by a low toxicity.

Examples of preferred compounds having a metal element with an atomic number of 20 or more and one or more non-metal elements, are Caesium iodide (CsI), Gadolinium oxysulphide ($Gd_2O_2S$), Barium fluorobromide (BaFBr), Calcium tungstate ($CaWO_4$), Barium titanate (BaTiOs), Gadolinium oxide ($Gd_2O_3$), Barium chloride ($BaCl_2$), Barium fluoride ($BaF_2$), Barium oxide (BaO), Cerium oxides, Caesium nitrate ($CsNO_3$), Gadolinium fluoride ($GdF_2$), Palladium iodide ($PdI_2$), Tellurium dioxide ($TeO_2$), Tin iodides, Tin oxides, Barium sulphides, Barium carbonate ($BaCO_3$), Barium iodide, Caesium chloride (CsCl), Caesium bromide (CsBr), Caesium fluoride (CsF), Caesium sulphate ($Cs_2SO_4$), Osmium halides, Osmium oxides, Osmium sulphides, Rhenium halides, Rhenium oxides, Rhenium sulphides, BaFX (wherein X represents Cl or I), $RFX_n$ (wherein RF represents lanthanides selected from: La, Ce, Pr, Nd, Pm, Sm, Eu, Gd, Tb, Dy, Ho, Er, Tm, Yb, Lu and X represents halides selected from: F, Cl, Br, I), $RF_yO_z$, $RF_y(SO_4)_z$, $RF_yS_z$ and/or $RF_y(WO_4)_z$,

wherein n, y, z are independently an integer number higher than 1. These compounds can produce lower weight X-ray shields and are easy to handle due to their low hygroscopicity than their pure metal analogues. The most preferred metallic compounds are: $Gd_2O_2S$, $Gd_2O_3$, $Ce_2O_3$, $CsI$, $BaFBr$, $CaWO_4$, $YTaO_4$ and $BaO$.

It is another advantage of the present invention that the range of metal elements which can be used for the X-ray absorbing layer, is much larger than the corresponding range of the pure metals and/or alloys, since many of them are not stable in their elemental form. Examples are the alkali metals, the alkaline earth metals and the rare-earth metals. Additionally the X-ray shield of the present invention allows the flexible adjustment to X-ray apparatus in such a way that the thickness of the X-ray absorbing layer is determined in reference to the allowable dose limit required to attenuate radiation.

The chemical compounds having a metal element with an atomic number of 20 or more and one or more non-metal elements may be used in the X-ray absorbing layer of the present invention as powder dispersed in a binder. The amount of the binder in the X-ray absorbing layer in weight percent can vary in the range from 1% to 50%, preferably from 1% to 25%, more preferably from 1% to 10%, most preferably from 1% to 3%.

Suitable binders are e.g. organic polymers or inorganic binding components. Examples of suitable organic polymers are polyethylene glycol acrylate, acrylic acid, butenoic acid, propenoic acid, urethane acrylate, hexanediol diacrylate, copolyester tetracrylate, methylated melamine, ethyl acetate, methyl methacrylate. Inorganic binding components may be used as well. Examples of suitable inorganic binding components are alumina, silica or alumina nanoparticles, aluminium phosphate, sodium borate, barium phosphate, phosphoric acid, barium nitrate.

Preferred binders are organic polymers such as cellulose acetate butyrate, polyalkyl (meth)acrylates, polyvinyl-n-butyral, poly(vinylacetate-co-vinylchloride), poly(acrylonitrile-co-butadiene-co-styrene), poly(vinyl chloride-co-vinyl acetate-co-vinylalcohol), poly(butyl acrylate), poly(ethyl acrylate), poly(methacrylic acid), poly(vinyl butyral), trimellitic acid, butenedioic anhydride, phthalic anhydride, polyisoprene and/or a mixture thereof. Preferably, the binder comprises one or more styrene-hydrogenated diene block copolymers, having a saturated rubber block from polybutadiene or polyisoprene, as rubbery and/or elastomeric polymers. Particularly suitable thermoplastic rubbers, which can be used as block-copolymeric binders, in accordance with this invention, are the KRATON™ G rubbers, KRATON™ being a trade name from SHELL.

In case the coating of the X-ray absorbing layer is to be cured, the binder includes preferably a polymerizable compound which can be a monofunctional or polyfunctional monomer, oligomer or polymer or a combination thereof. The polymerizable compounds may comprise one or more polymerizable groups, preferably radically polymerizable groups. Any polymerizable mono- or oligofunctional monomer or oligomer commonly known in the art may be employed. Preferred monofunctional monomers are described in EP1637322 A paragraph [0054] to [0057]. Preferred oligofunctional monomers or oligomers are described in EP1637322A paragraphs [0059] to [0064]. Particularly preferred polymerisable compound are urethane (meth)acrylates and 1,6-hexanedioldiacrylate. The urethane (meth)acrylates are oligomer which may have one, two, three or more polymerisable groups.

Suitable solvents, to dissolve the binder being an organic polymer during the preparation of the coating solution of the X-ray absorbing layer can be acetone, hexane, methyl acetate, ethyl acetate, isopropanol, methoxy propanol, isobutyl acetate, ethanol, methanol, methylene chloride and water. The most preferable ones are toluene, methyl-ethyl-ketone (MEK) and methyl cyclohexane. To dissolve suitable inorganic binding components, water is preferable as the main solvent. In case of a curable coating liquid, one or more mono and/or difunctional monomers and/or oligomers can be used as diluents. Preferred monomers and/or oligomers acting as diluents are miscible with the above described urethane (meth)acrylate oligomers. The monomer(s) or oligomer(s) used as diluents are preferably low viscosity acrylate monomer(s).

The X-ray absorbing layer of the present invention may also comprise additional compounds such as dispersants, plasticizers, photoinitiators, photocurable monomers, antistatic agents, surfactants, stabilizers oxidizing agents, adhesive agents, blocking agents and/or elastomers.

Dispersants which can be used in the present invention include non-surface active polymers or surface-active substances such as surfactants, added to the binder to improve the separation of the particles of the chemical compound having a metal element with an atomic number of 20 or more and one or more non-metal elements and to further prevent settling or clumping in the coating solution. Suitable examples of dispersants are Stann JF95B from Sakyo and Disperse Ayd™ 1900 from Daniel Produkts Germany. The addition of dispersants to the coating solution of the X-ray absorbing layer improves further the homogeneity of the layer.

Suitable examples of plasticizers are Plastilit™ 3060 from BASF, Santicizer™ 278 from Solutia Europe and Palatinol™ C from BASF. The presence of plasticizers to the X-ray absorbing layer improves the compatibility with flexible substrates.

Suitable photo-initiators are disclosed in e.g. J.V. Crivello et al. in " Photoinitiators for Free Radical, Cationic & Anionic Photopolymerisation 2nd edition", Volume III of the Wiley/SITA Series In Surface Coatings Technology, edited by G. Bradley and published in 1998 by John Wiley and Sons Ltd London, pages 276 to 294.Examples of suitable photoinitiators can be Darocure™ 1173 and Nuvopol™ PI-3000 from Rahn. Examples of suitable antistatic agents can be Cyastat™ SN50 from Acris and Lanco™ STAT K 100N from Langer.

Examples of suitable surfactants can be Dow Corning™ 190 and Gafac RM710, Rhodafac™ RS-710 from Rodia. Examples of suitable stabilizer compounds can be Brij™ 72 from ICI Surfactants and Barostab™ MS from Baerlocher Italia. An example of a suitable oxidizing agent can be lead (IV) oxide from Riedel De Haen. Examples of suitable adhesive agents can be Craynor™ 435 from Cray Valley and Lanco™ wax TF1780 from Noveon. An example of a suitable blocking agent can be Trixene™ BI7951 from Baxenden. An example of a suitable elastomer compound can be Metaline ™ from Schramm).

The thickness of the X-ray absorbing layer can vary as well and depends on the necessary shielding power and/or the space available to incorporate the X-ray shield in the design of the RFPD. In the present invention, the thickness of the X-ray absorbing layer can be at least 0.1 mm, more preferably in the range from 0.1 mm to 1.0 mm.

Depending on the application, the coating weight of the chemical compound having a metal element with an atomic number of 20 or more and one or more non metal elements the X-ray shields can be adjusted and in case of using a RFPD for medical purposes, this coating weight is preferably at least 100 mg/cm$^2$, more preferably at least 200 mg/cm$^2$.

## Substrate for the X-ray absorbing layer

The substrate for the X-ray absorbing layer of the X-ray shield according to the invention, hereafter denoted as the second substrate, can be either rigid or flexible, such as an aluminium plate, an aluminium foil, a film of polyethylene terephthalate (PET), polyethylene naphthalate (PEN), polyimide (PI), polyethersulphone (PES), a metal foil, a carbon fibre reinforced plastic (CFRP) sheet, glass, flexible glass, triacetate and a combination thereof or laminates thereof. Preferred materials for the second substrate of the invention are PET, glass and aluminium due to their low weight, their low cost and their availability.

Suitable substrates for the invention also include substrates which are substantially not transparent to light by incorporating a light absorbing or light reflecting material into the substrate.

More preferable substrates are flexible sheets obtained from for example PET, aluminium or flexible glass. The application of an X-ray absorbing layer onto the substrate (2$^{nd}$ substrate) as described above is preferably done by means of a coating method. Coating is an economically efficient technique of application of one or more layers onto a substrate. By means of coating techniques, the X-ray absorbing layer can be applied together with light absorbing or light reflecting layers, adhesion layers etc. Flexible substrates are particularly suitable for a continuous coating process. Moreover, flexible substrates can be available as rolls and they can be wound and un-wound in the production process of coating and drying or curing.

White coloured layers may be used to reflect light emitted by the scintillating phosphor in the X-ray absorbing layer. Layers comprising $TiO_2$ are preferably used to reflect 90% or more light at the wavelength(s) of the light emitted by the scintillating phosphor. The solid content of $TiO_2$ in the light reflecting layer is preferably in the range of 25 to 50 (wt.)%. and the thickness is preferably in the range of 5 to 40 $\mu$m. More preferably, the solid content of the $TiO_2$ is 33 to 38(wt.)% of the total solid content of the layer and the layer thickness is between 13 and 30 $\mu$m.

In another preferred embodiment of the invention, black coloured layers can be used to absorb light emitted by a scintillating phosphor in the X-ray absorbing layer because of their high efficiency to absorb light. Black particles, such as fine carbon black powder (ivory black, titanium black, iron black), are suitable to obtain sufficient absorption of emitted light by the scintillating phosphor. Preferably the solid content of carbon black is in the range of 3 to 30 (wt.)% and a layer thickness of 2 to 30 $\mu$m will absorb 90% or more of the emitted light by the scintillating phosphor. More preferably the range of the solid content of the carbon black is in the range of 6 to 15 (wt.)% and the layer thickness between 5 and15 $\mu$m. In another embodiment of the invention, coloured pigments or dyes absorbing specifically at the maximal wavelength of the emitted light by the scintillating phosphor in the X-ray absorbing layer can be used.

## Scintillator

In the RFPD for indirect conversion direct radiography according to the present invention, the scintillator comprises optionally a support and provided thereon, a scintillating phosphor such as $Gd_2O_2S:Tb$, $Gd_2O_2S:Eu$, $Gd_2O3:Eu$, $La_2O_2S:Tb$, $La_2O_2S$, $Y_2O_2S:Tb$, CsI:TI, CsI:Eu, CsI:Na, CsBr:Tl, NaI:TI, $CaWO_4$, $CaWO_4:Tb$, BaFBr:Eu, BaFCl:Eu, $BaSO_4:Eu$, $BaSrSO_4$, $BaPbSO_4$, $BaAl_{12}O_{19}:Mn$, $BaMgAl_{10}O_{17}:Eu$, $Zn_2Sio_4:Mn$, (Zn, Cd)S:Ag, LaOBr, LaOBr:Tm, $Lu_2O_2S:Eu$, $Lu_2O_2S:Tb$, $LuTaO_4$, $HfO_2:Ti$, $HfGe0_4:Ti$, $YTa0_4$, $YTa0_4:Gd$, $YTa0_4:Nb$, $Y_2O3:Eu$, $YBO_3:Eu$, $YBO_3:Tb$, or $(Y,Gd)BO_3:Eu$, or combinations thereof. Besides crystalline scintillating phosphors, scintillating glass or organic scintillators can also be used.

When evaporated under appropriate conditions, a layer of doped CsI will condense in the form of needle like, closely packed crystallites with high packing density onto a support. Such a columnar or needle-like scintillating phosphor is known in the art. See, for example, ALN Stevels et al. , "Vapor Deposited CsI:Na Layers: Screens for Application in X-Ray Imaging Devices, " Philips Research Reports 29:353-362 (1974); and T. Jing et al, "Enhanced Columnar Structure in CsI Layer by Substrate Patterning", IEEE Trans. Nucl. Sci. 39: 1195-1198 (1992). More preferably, the scintillating phosphor layer includes doped CsI.

A blend of different scintillating phosphors can also be used. The median particle size is generally between about 0. 5 $\mu$m and about 40 $\mu$m. A median particle size of between 1 $\mu$m and about 20 $\mu$m is preferred for ease of formulation, as well as optimizing properties, such as speed, sharpness and noise. The scintillator for the embodiments of the present invention can be prepared using conventional coating techniques whereby the scintillating phosphor powder, for example $Gd_2O_2S$ is mixed with a solution of a binder material and coated by means of a blade coater onto a substrate. The binder can be chosen from a variety of known organic polymers that are transparent to X-rays, stimulating, and emitting light. Binders commonly employed in the art include sodium o-sulfobenzaldehyde acetal of poly(vinyl alcohol); chloro-sulfonated poly(ethylene); a mixture of macromolecular bisphenol poly(carbonates) and copolymers comprising bisphenol carbonates and poly(alkylene oxides);aqueous ethanol soluble nylons; poly(alkyl acrylates and methacrylates) and copolymers of poly(alkyl acrylates and methacrylates with acrylic and methacrylic acid); poly(vinyl butyral); and poly(urethane) elastomers. Other preferable binders which can be used are described above in the section of the X-ray absorbing layer. Any conventional ratio phosphor to binder can be employed. Generally, the thinner scintillating phosphor layers are, the sharper images are realized when a high weight ratio of phosphor to binder is employed. Phosphor-to-binder ratios in the range of about 70:30 to 99:1 by weight are preferable.

### The photoconductive layer

In the RFPD for direct conversion direct radiography not covered by the claimed invention, the photoconductive layer is usually amorphous selenium, although other photoconductors such as HgI2, PbO, PbI2, TlBr, CdTe and gadolinium compounds can be used. The photoconductive layer is preferentially deposited on the imaging array via vapour deposition but can also been coated using any suitable coating method.

### The imaging array and first substrate

The single imaging array used in the invention for indirect conversion direct radiography is based on an indirect conversion process which uses several physical components to convert X-rays into light that is subsequently converted into electrical charges. First component is a scintillating phosphor which converts X-rays into light (photons). Light is further guided towards an amorphous silicon photodiode layer which converts light into electrons and electrical charges are created. The charges are collected and stored by the storage capacitors. A thin-film transistor (TFT) array adjacent to amorphous silicon read out the electrical charges and an image is created. Examples of suitable image arrays are disclosed in US5262649 and by Samei E. et al., "General guidelines for purchasing and acceptance testing of PACS equipment", Radiographics, 24, 313-334 . Preferably, the imaging arrays as described in US2013/0048866, paragraph [90-125] and US2013/221230, paragraphs [53-71] and [81-104] can be used.

The single imaging array for direct conversion direct radiography is based on a direct conversion process of X-ray photons into electric charges. In this array, an electric field is created between a top electrode, situated on top of the photoconductor layer and the TFT elements. As X-rays strike the photoconductor, the electric charges are created and the electrical field causes to move them towards the TFT elements where they are collected and stored by storage capacitors. Examples of suitable image arrays are disclosed by Samei E. et al., " General guidelines for purchasing and acceptance testing of PACS equipment", Radiographics, 24, 313-334.

For both the direct and indirect conversion process, the charges must be read out by readout electronics. Examples of readout electronics in which the electrical charges produced and stored are read out row by row, are disclosed by Samei E. et al., Advances in Digital Radiography. RSNA Categorical Course in Diagnostic Radiology Physics (p. 49-61) Oak Brook, Ill.

The substrate of the imaging array of the present invention, hereafter denoted as the 'first substrate' is usually glass. However, imaging arrays fabricated on substrates made of plastics, metal foils can also be used. The imaging array can be protected from humidity and environmental factors by a layer of silicon nitride or polymer based coatings such as fluoropolymers, polyimides, polyamides, polyurethanes and epoxy resins. Also polymers based on B-staged bisbenzocyclobutene-based (BCB) monomers can be used. Alternatively, porous inorganic dielectrics with low dielectric constants can also be used.

### The underlying electronics

The underlying electronics, situated under the X-ray absorbing layer comprise a circuit board which is equipped with electronic components for processing the electrical signal from the imaging array, and/or controlling the driver of the imaging array and is electrically connected to the imaging array.

**Method of making the radiographic flat panel detector**

**Method of making the X-ray shield**

The X-ray shield of the present invention can be obtained by applying a coating solution comprising at least one chemical compound having a metal element with an atomic number of 20 or more and one or more non-metal elements and a binder onto a substrate ($2^{nd}$ substrate) by any known methods, such as knife coating, doctor blade coating, spin-coating, dip-coating, spray-coating, screen printing and lamination. The most preferable method is the doctor blade coating.

In a preferred embodiment the coating solution is prepared by first dissolving the binder in a suitable solvent. To this solution the chemical compound having a metal element with an atomic number of 20 or more and one or more non-metal elements is added. To obtain a homogenous coating solution or lacquer, a homogenization step or milling step of the mixture can be included in the preparation process. A dispersant can be added to the binder solution prior to the mixing with the chemical compound having a metal element with an atomic number of 20 or more and one or more non-metal elements. The dispersant improves the separation of the particles in the coating solution and prevents settling or clumping of the ingredients in the coating solution. The addition of dispersants to the coating solution of the X-ray absorbing layer decreases the surface tension of the coating solution and improves the coating quality of the X-ray absorbing layer.

In another embodiment of the invention, the binder being a polymerisable compound can be dissolved in diluents comprising one or more mono and/or difunctional monomers and/or oligomers.

After stirring or homogenization the coating solution is applied onto the substrate preferably using a coating knife or a doctor blade. The substrate can be the first substrate or a second substrate. If the coating solution is coated on the first substrate, the coating is preferably performed on the side opposite to the imaging array. After the coating of the X-ray absorbing layer onto a substrate, the X-ray absorbing layer can be dried via an IR-source, an UV-source, a heated metal roller or heated air. When photocurable monomers are used in the coating solution, the coated layer can be cured via heating or via an UV-source. After drying or curing, the X-ray shield which is coated on a second substrate can be cut into sheets of appropriate size.

The obtained X-ray shield, comprising a substrate and an X-ray absorbing layer comprising a binder and a chemical compound having a metal element with an atomic number of 20 or more and one or more non-metal elements, can be used as to shield electronics in medical apparatus and non-destructive testing apparatus from X-rays. The combination of the X-ray absorbing layer with a substrate, gives the whole X-ray shield sufficient mechanical strength to be used as a self-contained component in medical devices or non-destructive testing devices.

**Method of making the RFPD for indirect conversion direct radiography**

The RFPD for indirect conversion direct radiography according to the invention is made by assembling the different components which are described above. A preferred method is now described.

In a first step, the scintillator, which comprises a scintillating phosphor and a support, is coupled via gluing onto the single imaging array situated on the first substrate, preferably glass. Gluing is done with pressure sensitive adhesives or hot melts. Preferably a hot melt is used. Suitable examples of hot melts are polyethylene-vinyl acetate, polyolefins, polyamides, polyesters, polyurethanes, styrene block copolymers, polycarbonates, fluoropolymers, silicone rubbers, polypyrrole. The most preferred ones are polyolefins and polyurethanes due to the higher temperature resistance and stability. The hot melt is preferably thinner than 25 $\mu$m. The hot melt with a lining is placed onto the surface of the imaging array. The imaging array on the first substrate, together with the hot melt is then heated in an oven at a prescribed temperature. After cooling, the lining is removed and releases a melted hot melt with a free adhesive side. The scintillator is coupled to the imaging array by bringing the scintillating phosphor layer in contact with the adhesive side of the hot melt and by applying a high pressure at a high temperature. To achieve a good sticking over the complete area of the imaging array, a pressure in a range from 0.6 to 20 bars has to be applied and a temperature value in a range from 80 - 220° C, during between 10 and 1000 s is required. A stack of scintillator-imaging array-first substrate is thereby formed. In one preferred embodiment of the invention, this stack can be positioned above the underlying electronics which perform the processing of the electrical signal from the imaging array, or the controlling of the driver of the imaging array.

In the last step, the X-ray shield is coupled to the first substrate at the opposite side of the single imaging array. Either the second substrate or the X-ray absorbing layer of the X-ray shield can be contacted with the first substrate. A preferable method is after making of the contact, to immobilise the components of the obtained stack by cold roll lamination or heated roll lamination using foils having a protective ability. The best suitable foils are the polyethylene, polyester, polyvinylchloride or acrylic based foils with a thickness of maximum 100$\mu$m. Another preferable method is using a pressure sensitive glue or hot melt. A hot melt with a lining is placed onto either the substrate ($2^{nd}$ substrate) or the X-ray absorbing layer of the X-ray shield. The X-ray shield is then heated, preferably in an oven at the prescribed temperature.

After cooling, the lining is removed and releases a melted hot melt with a free adhesive side. The X-ray shield is coupled to the imaging array by bringing the first substrate of the stack into contact with the adhesive side of the hot melt and by applying a high pressure at a high temperature. To achieve a good sticking over the complete area of the components to be glued, a pressure in a range from 0.6 to 20 bars has to be applied and a temperature value in a range from 80 - 220°C, during between 10 and 1000 s is required.

In a preferred embodiment of the invention, the scintillating phosphor is directly applied on the single imaging array via a coating or deposition process. This method has the advantage that no gluing is required and hence omits at least one step in the production process of the RFPD.

**Method of making the RFPD for direct conversion direct radiography**

The FPD for direct conversion direct radiography not covered by the claimed invention is made by assembling the different components which are described above.

A preferred method is as follows: the photoconductor, preferably amorphous selenium is deposited onto the single imaging array situated on the first substrate which is preferably glass. Examples of deposition methods are disclosed in Fischbach et al.,'Comparison of indirect Csl/a:Si and direct a:Se digital radiography', Acta Radiologica 44 (2003) 616-621. After providing a top electrode on top of the photoconductive layer, the single imaging array with the photoconductor is coupled with the X-ray shield. This can be done according to the same methods as described for making the RFPD for indirect conversion direct radiography.

**EXAMPLES**

**1. Measurement methods**

1.1 X-ray shielding capacity of the X-ray shields

The X-ray shielding capacity of X-ray shields according to the present invention (INV) and of a commercially available metal based X-ray shield (COMP) was measured based on measurements of the optical density of a radiographic film placed between scintillator and X-ray shield, after X-ray exposure and development. The radiographic film is commercially available from Agfa Healthcare (AGFAHDRC1824) and is a green sensitive film with one radiation sensitive side. The X-ray exposure was performed with a Philips Optimus 80 X-ray source. The X-ray shield was usually positioned in the following configuration: scintillator - radiographic film - X-ray shield - scattering elements comprising a printed circuit board (PCB), a lead strip and a PMMA block. This configuration is called the standard configuration of the RFPD. The default scintillating phosphor used was a commercially available GOS scintillator (CAWO Superfine 115 SW, from CAWO). The scintillating phosphor layer was put in contact with the radiation sensitive side of the radiographic film. The underlying electronics of a RFPD were simulated by the PCB with discrete components, the lead strip and the block of poly(methylmethacrylate). Poly(methylmethacrylate) is used due to its very high scattering properties.

To achieve good contact between the components, each X-ray shield was sealed in a black polyethelene bag (PE, Type B, 260x369 mm, 0,19mm thickness, from Cornelis Plastic) together with the scintillator and the radiographic film by means of vacuum. The substrate of the X-ray shield was always in contact with the non-radiation sensitive side of the radiographic film, unless otherwise specified. The package prepared like this way, is called a basic RFPD.

The X-ray source, the basic RFPD and the scattering elements were mounted on a horizontal bench. The basic RFPDs were placed at 1.5 m from said X-ray source. Behind the basic RFPD, the block of PMMA, the strip of lead of 3 mm thickness and the PCB, were placed next to each other to simulate the underlying electronics of the RFPD. The distance between the scattering elements and the basic RFPD was less than 0.2 cm. The reference measurement was done with the basic RFPD configuration without scattering elements behind the RFPD.

Following standard radiation X-ray beam qualities were used: RQA3 (10 mm Al, 52kV), RQA5 (21 mm Al, 73kV), RQA7 (30 mm Al, 88kV), and RQA9 (40 mm Al, 117kV), RQA X-ray beam qualities as defined in IEC standard 61267, 1st Ed. (1994).

After exposure each film was developed in G138i (Agfa Healthcare) at 33° C for 90s. and placed in a MacBeth densitometer, type TR-924 to measure the optical density. The higher the measured optical density, the more backscatter of X-rays was taking place.

1.2. Weighing of the X-ray shields:

The X-ray shields prepared according to the present invention (INV) and the comparative X-ray shield (COMP) were weighed on the laboratory scales (Mettler Toledo PG5002-S) with a resolution of 0.01g.

1.3. X-ray absorption of the X-ray shields:

The X-ray absorption of the X-ray shields was measured with a Philips Optimus 80 apparatus together with a Triad dosimeter having a 30cc volume cell. The measuring cell was placed at 1.5 m distance from the X-ray source directly behind the X-ray shield. The X-ray shield in both cases was placed with its substrate directed to the X-ray source. Data for each screen were collected multiple times and the average value was calculated together with the standard deviation.

All tests were done for standard radiation X-ray beam qualities (RQA X-ray beam qualities as defined in IEC standard 61267, 1st Ed. (1994)): RQA3 (10 mm Al, 52kV), RQA5 (21 mm Al, 73kV), RQA7 (30 mm Al, 88kV), and RQA9 (40 mm Al, 117kV) unless otherwise specified.

**2. Materials**

The materials used in the following examples were readily available from standard sources such as ALDRICH CHEMICAL Co. (Belgium), ACROS (Belgium) and BASF (Belgium) unless otherwise specified. All materials were used without further purification unless otherwise specified.

- Gadolinium oxysulphide ($Gd_2O_2S$) or GOS: (CAS 12339-07-0) powder was obtained from Nichia, mean particle size: 3.3 $\mu$m.
- $CaWO_4$, powder was obtained from Nichia, mean particle size: 7.0 $\mu$m.
- $YTaO_4$, powder was obtained from Nichia, mean particle size: 4.4 $\mu$m.
- White PET substrate: polyethylene terephthalate (PET) film with a thickness of 0.19 mm, obtained from Mitsubishi, trade name Hostaphan WO.
- Black PET substrate: polyethylene terephthalate (PET) film a thickness of 0.188 mm, obtained from Toray, trade name Lumirror X30.
- Disperse Ayd™ 9100 (Disperse Ayd™ W-22), anionic surfactant/Fatty Ester dispersant (from Daniel Produkts Company).
- Kraton™ FG1901X (new name = Kraton™ FG1901 GT), a clear, linear triblock copolymer based on styrene and ethylene/butylene with a polystyrene content of 30%, from Shell Chemicals.
- Default GOS scintillator, CAWO Superfine 115 SW, from CAWO.
- Caesium Iodide (CsI): (CAS 7789-17-5) powder from Rockwood Lithium, 99.999%.
- Aluminium 318G: plate from Alanod having a thickness of 0.3 mm.
- Imaging array: TFT (according US2013/0048866, paragraph [90-125] and US2013/221230, paragraphs [53-71] and [81-104]) on Corning Lotus™ Glass having a thickness of 0.7 mm.
- Radiographic film: AGFAHDRC1824, from Agfa Healthcare
- PMMA: poly(methylmethacrylate), 7 cm thick, 30x30cm, compliant with ISO 9236-1 standard
- Lead strip: 13cm x 2.5 cm, thickness is 0.3 cm.
- PCB: 13cm x 4.5 cm

**3. Preparation of X-ray shields**

3.1 Preparation of the solution for coating the X-ray absorbing layer:

4.5 g of binder (Kraton™ FG1901X) was dissolved in 18 g of a solvent mixture of toluene and MEK (ratio 75:25 wt. / wt.) and stirred for 15 min at a rate of 1900 r.p.m. The chemical compound having a metal element with an atomic number of 20 or more and one or more non-metal elements, was added thereafter as a powder, in an amount of 200g and the mixture was stirred for another 30 minutes at a rate of 1900 r.p.m.

3.2 Preparation of X-ray shields SD-01 to SD-20 (INV):

The coating solution as obtained in § 1.1 was coated with a doctor blade at a coating speed of 4 m/min onto several PET substrates (white and black) to obtain different dry layer thicknesses variable from 100 to 450 $\mu$m to obtain X-ray shields SD-01 to SD-20 (see Table 1). Subsequently, the X-ray shields were dried at room temperature during 30 minutes. In order to remove volatile solvents as much as possible the coated X-ray shields were dried at 60°C for 30 minutes and again at 90°C for 20 to 30 minutes in a drying oven. The total thickness of the X-ray absorbing layer was controlled by adjusting the wet layer thickness and/or the number of layers coated on top of each other after drying each layer. The wet layer thickness has a value between 220 $\mu$m and 1500 $\mu$m. The size of the obtained shields was 18 cm X 24 cm.

After coating, each X-ray shield was weighed and the coating weight of the chemical compound having a metal element with an atomic number of 20 or more and one or more non metal elements was obtained by applying formula 1. The results are reported in Table 1

$$\frac{(W_F - W_S)}{A_S} * P\%$$

## Formula 1

Where:

$W_F$ is the weight of an X-ray shield (2nd substrate + X-ray absorbing layer),
Ws is the weight of the substrate (2nd substrate) of the X-ray shield,
$A_S$ is the surface area of the substrate (2nd substrate),
P% is the amount in weight % of the chemical compound having a metal element with an atomic number of 20 or more and one or more non-metal elements in the X-ray absorbing layer.

3.3 Molybdenum X-ray shield SD-21 (COMP)

An X-ray shield consisting of a plate of Molybdenum was obtained from one of the commercially available RFPDs on the market. The thickness of the Molybdenum plate was 0.3 mm and the size was 18 cm X 24 cm. The Molybdenum plate did not contain a substrate. The composition of the plate was 99.85% (wt.) of Mo, and below 0.05% (wt.) of Na, K, Ca, Ni, Cu, and Bi.

The coating weight for this Mo plate was calculated based on formula 1 taking into account that P% is 100 and Ws is 0. The results of the calculated coating weight of the Mo plate, hereafter denoted as SD-21 were reported in Table 1.

Table 1: Coating weights of the inventive X-ray shields (SD-01 to SD-20) and of Mo in the comparative X-ray shield (SD-21).

### Table 1

| X-ray shield | Chemical compound having a metal element with an atomic number of 20 or more and one or more non-metal elements in the X-ray absorbing layer | Substrate | Coating weight (mg/cm$^2$) |
|---|---|---|---|
| SD-01 | GOS | Black PET | 110 |
| SD-02 | GOS | Black PET | 152 |
| SD-03 | GOS | White PET | 129 |
| SD-04 | GOS | White PET | 121 |
| SD-05 | GOS | White PET | 116 |
| SD-06 | GOS | White PET | 108 |
| SD-07 | GOS | White PET | 100 |
| SD-08 | GOS | White PET | 96 |
| SD-09 | GOS | White PET | 81 |
| SD-10 | GOS | White PET | 115 |
| SD-11 | GOS | White PET | 40 |
| SD-12 | GOS | White PET | 80 |
| SD-13 | GOS | White PET | 171 |
| SD-14 | GOS | White PET | 195 |

(continued)

| X-ray shield | Chemical compound having a metal element with an atomic number of 20 or more and one or more non-metal elements in the X-ray absorbing layer | Substrate | Coating weight (mg/cm$^2$) |
|---|---|---|---|
| SD-15 | GOS | White PET | 145 |
| SD-16 | GOS | White PET | 230 |
| SD-17 | GOS | Black PET | 115 |
| SD-18 | GOS | Black PET | 155 |
| SD-19 | $CaWO_4$ | White PET | 75 |
| SD-20 | $YTaO_4$ | White PET | 82 |
| SD-21 | - | - | 302 |

3.4 Preparation of X-ray shields with and without a dispersant

To illustrate the difference between X-ray shields based on GOS and prepared with or without a dispersant in the coating solution of the X-ray absorbing layer, two X-ray shields were prepared according to the method described in §3.1. In both cases a white PET substrate was used. The coating weight of GOS was 172 mg/cm$^2$ for both shields. Shield SD-00.1 was prepared without dispersant in the coating solution and SD-00.2 was prepared with dispersant (Disperse Ayd™ 9100) added to the coating solution. Firstly, 0.5 g of dispersant was dissolved in 11.21 g of a toluene and methyl-ethyl-ketone (MEK) solvent mixture, having a ratio of 75:25 (w/w) and mixed with the binder solution as prepared in §3.1. The further preparation steps are the same as in §3.1 and §3.2. The X-ray absorption of both shields was determined according to the measuring method 3 with a RQA5 X-ray beam quality and a load of 6.3mAs. The results are shown in Table 2.

Table 2: X-ray absorption of GOS X-ray shields prepared with or without dispersant.

**Table 2**

| X-ray shield | Dispersant | Homogeneity of coated X-ray absorbing layer | Thickness of the X-ray absorbing layer ($\mu$m) | Weight (g) | X-ray absorption (%) |
|---|---|---|---|---|---|
| SD-00.1 (INV) | No | good | 325 | 152.15 | 65.51 $\pm$2.5 |
| SD-00.2 (INV) | Yes | perfect | 325 | 152.50 | 63.80$\pm$3.0 |

As shown in Table 2, the X-ray shield prepared with the dispersant present in the coating solution had a more homogeneous X-ray absorbing layer for a comparable weight and X-ray absorption as the X-ray shield prepared without dispersant. The presence of the dispersant is advantageous for the preparation process of the shields since it further reduces the surface tension and prevents the floating of $\mu$m size particles.

**4. X-ray shielding capacity of inventive X-ray shields in comparison with the comparative shield.**

The X-ray shielding capacity of the inventive X-ray shields SD-17 and SD-18 was therefore measured according measuring method 1.1 in a standard configuration of the RFPD in comparison with the comparative Mo plate X-ray shield (SD-21). The X-ray shielding capacity of the inventive X-ray shields SD-19 and SD-20 was measured according measuring method 1.1 in a configuration wherein the scattering elements consist of a lead strip and a PMMA block, in comparison with the comparative Mo plate X-ray shield (SD-21). The X-ray shields, which had the same surface, were weighed according to measuring method 1.2. The results are shown in Table 3.

Table 3: Difference in optical density of the radiographic film with the inventive X-ray shields compared to the comparative shield SD-21.

**Table 3**

| No. | X-ray beam quality | X-ray shield | Weight (g) | Difference in optical density |
|---|---|---|---|---|
| 7 | RQA3 and RQA5 | SD-17(INV) | 74.69 | Decrease |
| 8 | RQA7 | SD-17(INV) | 74.69 | Slight increase |
| 9 | RQA9 | SD-17(INV) | 74.69 | Increase |
| 10 | RQA3 and RQA5 | SD-18(INV) | 102.47 | Decrease |
| 11 | RQA7 | SD-18(INV) | 102.47 | Equal |
| 12 | RQA9 | SD-18(INV) | 102.47 | Slight increase |
| 13 | RQA3 | SD-19(INV) | 109.00 | Decrease |
| 14 | RQA5 | SD-19(INV) | 109.00 | Decrease |
| 15 | RQA3 | SD-20(INV) | 119.00 | Decrease |
| 16 | RQA5 | SD-20(INV) | 119.00 | Equal |
| 17 | - | SD-21 (COMP) | 163.46 | - |

These results show that the shielding capacity of the inventive shields are equal or higher than the comparative X-ray shield based on a Molybdenum plate and in some cases only a bit lower, but that their weight is significantly lower than the comparative X-ray shield.

**Example 1: Preparation of RFPDs comprising different X-ray shields**

RFPDs for indirect conversion direct radiography were prepared by bringing a scintillator in contact with the above mentioned imaging array on a glass substrate (Corning Lotus™ Glass). Subsequently this package was brought into contact with different X-ray shields SD-01 to SD-18 and the Molybdenum metal plate SD-21.

To assure good optical contact between each layer of the RFPDs, a hot melt layer based on polyurethane and not thicker than 25 $\mu$m, was used. Two types of scintillators were used: i) a powder-based scintillating phosphor GOS (CAWO Superfine 115 SW from CAWO) and ii) a needle-based scintillating phosphor CsI deposited on the aluminium 318G substrate with a coating weight of CsI of 120 mg/cm$^2$. The CsI based scintillator was prepared as follows: 400g of CsI was placed in a container in a vacuum deposition chamber. The pressure in the chamber was decreased to $5.10^{-5}$ mbar. The container was subsequently heated to a temperature of 680°C and the CsI was deposited on the aluminium support Al318G having a size of 24cm x 18cm. The distance between the container and the substrate was 20 cm. During evaporation, the substrate was rotated at 12 r.p.m. and kept at a temperature of 140°C. During the evaporation process argon gas was introduced into the chamber. The duration of the process is 160 min. After the evaporation process the X-ray shield was placed in the oven and kept for 1h at 170°C.

The scintillator was first coupled to the imaging array on the glass. The coupling was achieved by placing hot melt with a lining on the surface of the imaging array on the glass. The glass with the imaging array was then put into an oven and kept at a temperature of 85°C for 10 minutes. After cooling, the lining was removed to release the adhesive side of the melted hot melt. Subsequently, the scintillating phosphor layer of the scintillator was brought into contact with the adhesive surface of the hot melt at high pressure and high temperature. To achieve a good sticking over the complete area a pressure in a range of 0.8 bar was applied, at a temperature of 115°C, for 15 min.

In the following step, the X-ray shields were coupled to the glass substrate - imaging array - scintillator package. A polyurethane based hot melt of maximum 25$\mu$m thickness with a lining is placed onto the substrate (2nd substrate) of the X-ray shields SD-01 to SD-18 at the side opposite to the X-ray absorbing layer. With the use of the comparative shield, SD-21, the hot melt is applied directly on one side of the metal plate. The X-ray shields were put into the oven and kept at a temperature of 80°C for 10 minutes. After cooling, the lining was removed to release the adhesive side of the melted hot melt. Subsequently, the glass substrate carrying the imaging array and scintillator was brought into contact with the adhesive surface of the hot melt at a high pressure and a high temperature. To achieve a good sticking over the complete area a pressure of 0.8 bar was applied, with a temperature of 115°C, for 15 min.

Following RFPDs have been prepared according to the above described method:

a) DRGOS-01 to DRGOS-18: GOS scintillator + GOS X-ray shields SD-01 to SD-18 ,
b) DRCSI-01 to DRCSI-18: CsI scintillator + GOS X-ray shields SD-01 to SD-18 ,
c) DRGOS-19: GOS scintillator + Mo X-ray shield SD-21
d) DRCSI-19 : CsI scintillator + Mo X-ray shield SD-21

**Example 2: X-ray shielding capacity of different X-ray shields**

This example illustrates the X-ray shielding capacity of X-ray shields with different coating weights and different substrates (2nd substrate) in a standard configuration of the RFPD with different scattering elements. Therefore the ability of the inventive X-ray shields to reduce the backscatter of several X-ray shields prepared according to §3.1 - 3.3 and assembled in the standard RFPD configuration as described in measurement method 1.1, is demonstrated. The optical densities of the radiographic film exposed in the standard RFPD configurations are compared to the optical densities of the radiographic film exposed in a RFPD configuration without scattering elements. The tests were done with RQA X-ray beam qualities as described in the measurements method 1 and with loads for RQA3 - 12.5 mAs, RQA5 - 6.3 mAs, RQA7 - 5.6 mAs, and RQA9 - 3mAs. Table 4 shows the measured X-ray shielding capacities.

Table 4: Difference in optical density of the radiographic film with the X-ray shields in a specific configuration of the RFPD with respect to the X-ray shield in a RFPD configuration without scattering elements.

**Table 4**

| No. | RFPD configuration | X-ray shield | Difference in optical density |
|-----|---------------------|--------------|-------------------------------|
| 1 | standard | SD-01; SD-02 | Slight decrease |
| 2 | standard | SD-08; SD-09;SD-11 ;SD-12 | Slight decrease |
| 3 | standard | SD-03 to SD-07; SD-10, SD-13 to SD-16 | Strong decrease |
| 4 | Standard with only PMMA block | SD-03 to SD-16 | Decrease |
| 5 | Standard with only PMMA block | SD-01; SD-02 | Strong decrease |

The results show that all inventive X-ray shields in a RFPD are able to reduce the backscatter of X-rays originating from scattering elements which simulate the underlying electronics of the RFPD.

**Claims**

**1.** A method of making a radiography flat panel detector, comprising the steps of:

a) providing a first substrate (3) with an imaging array (2) on a side of the first substrate; and
b) gluing a scintillating phosphor layer which has been applied on a support, onto the imaging array; and
c) providing a second substrate (4); and
d) coating an X-ray absorbing layer (5) on a side of the second substrate (4), by means of a method selected from the group of knife coating, doctor blade coating, spin-coating, dip-coating, spray-coating, screen printing and lamination; the absorbing layer (5) comprises a binder and a chemical compound having a metal element with an atomic number of 20 or more and one or more non-metal elements; and
e) contacting either the side of the second substrate (4) opposite to the X-ray absorbing layer (5) or the X-ray absorbing layer (5) with the side of the first substrate (3) opposite to the imaging array (2); and
f) positioning underlying electronics (6) under the second substrate (4) or X-ray absorbing layer (5) and electrically connecting the underlying electronics (6) to the image array (2).

**2.** The method of making a radiography flat panel detector according to claim 1 further comprising the steps of mixing the chemical compound having a metal element with an atomic number of 20 or more and one or more non-metal elements with the binder in the presence of a solvent.

**Patentansprüche**

**1.** Ein Verfahren zur Herstellung eines Flachbildröntgendetektors, umfassend die folgenden Schritte:

a) Bereitstellen eines ersten Substrats (3) mit einer Bildgebungsmatrix (2) auf einer Seite des ersten Substrats, und

b) Aufkleben einer auf einen Träger aufgetragenen szintillierenden Leuchtstoffschicht auf die Bildgebungsmatrix, und

c) Bereitstellen eines zweiten Substrats (4), und

d) Auftrag einer Röntgenstrahlung absorbierenden Schicht (5) auf eine Seite des zweiten Substrats (4) mittels eines Verfahrens, ausgewählt aus Streichbeschichtung, Rakelbeschichtung, Wirbelbeschichtung, Tauchbeschichtung, Sprühbeschichtung, Siebdruck und Laminierung, wobei die absorbierende Schicht (5) ein Bindemittel und eine chemische Verbindung mit einem Metallelement mit einer Atomnummer von mindestens 20 und einem oder mehreren Nicht-Metallelementen enthält, und

e) Inkontaktbringen der der Röntgenstrahlung absorbierenden Schicht (5) gegenüberliegenden Seite des zweiten Substrats (4) oder der Röntgenstrahlung absorbierenden Schicht (5) mit der Seite des ersten Substrats (3), die der Bildgebungsmatrix (2) gegenüberliegt, und

f) Positionieren unterliegender Elektronik (6) unter dem zweiten Substrat (4) oder der Röntgenstrahlung absorbierenden Schicht (5) und Erstellen einer elektrischen Verbindung der unterliegenden Elektronik (6) mit der Bildgebungsmatrix (2).

**2.** Das Verfahren zur Herstellung eines Flachbildröntgendetektors nach Anspruch 1, ferner umfassend die Schritte, in denen die chemische Verbindung mit einem Metallelement mit einer Atomnummer von mindestens 20 und einem oder mehreren Nicht-Metallelementen in Gegenwart eines Lösungsmittels mit dem Bindemittel vermischt wird.

**Revendications**

**1.** Procédé pour la fabrication d'un capteur plan pour rayons X comprenant les étapes consistant à:

a) mettre à disposition un premier substrat (3) comprenant une matrice formatrice d'image (2) sur un côté du premier substrat, et

b) coller une couche luminescente scintillante appliquée sur un support sur la matrice de formation d'image, et

c) mettre à disposition un deuxième substrat (4), et

d) appliquer une couche absorbant les rayons X (5) sur un côté du deuxième substrat (4) à l'aide d'un procédé choisi parmi l'enduction à la lame, l'enduction à la racle, l'enduction par centrifugation, l'enduction par immersion, l'enduction par pulvérisation, la sérigraphie ou la stratification, ladite couche absorbante (5) contenant un liant et un composé chimique comprenant un élément métallique ayant un numéro atomique minimal de 20 et un ou plus plusieurs éléments non métalliques, et

e) mettre en contact le côté du deuxième substrat (4) opposé à la couche absorbant les rayons X (5) ou la couche absorbant les rayons X (5) avec le côté du premier substrat (3) opposé à la matrice formatrice d'image (2), et

f) positionner une électronique sous-jacente (6) sous le deuxième substrat (4) ou la couche absorbant les rayons X (5) et réaliser une connexion électrique de l'électronique sous-jacente (6) avec la matrice formatrice d'image (2).

**2.** Procédé pour la fabrication d'un capteur plan pour rayons X selon la revendication 1, comprenant en outre les étapes consistant à mélanger le composé chimique comprenant un élément métallique ayant un numéro atomique minimal de 20 et un ou plus plusieurs éléments non métalliques avec le liant en présence d'un solvant.

**Fig. 1**

**Fig. 2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1471384 B1
- US 20130032724 A1
- US 20120097857 A1
- US 7317190 B2
- US 5650626 A
- US 5777335 A
- US 7569832 B
- US 2008011960 A1

- WO 2005057235 A1
- WO 20051055938 A
- US 6548570 B
- WO 20090078891 A
- EP 1637322 A
- US 5262649 A
- US 20130048866 A
- US 2013221230 A

**Non-patent literature cited in the description**

- Photoinitiators for Free Radical, Cationic & Anionic Photopolymerisation. **J.V. CRIVELLO et al.** Wiley/SITA Series In Surface Coatings Technology. John Wiley and Sons Ltd, 1998, vol. III, 276-294
- **ALN STEVELS et al.** Vapor Deposited CsI:Na Layers: Screens for Application in X-Ray Imaging Devices. *Philips Research Reports,* 1974, vol. 29, 353-362
- **T. JING et al.** Enhanced Columnar Structure in CsI Layer by Substrate Patterning. *IEEE Trans. Nucl. Sci.,* 1992, vol. 39, 1195-1198

- **SAMEI E. et al.** General guidelines for purchasing and acceptance testing of PACS equipment. *Radiographics,* vol. 24, 313-334
- **SAMEI E. et al.** Advances in Digital Radiography. *RSNA Categorical Course in Diagnostic Radiology Physics,* 49-61
- **FISCHBACH et al.** Comparison of indirect CsI/a:Si and direct a:Se digital radiography. *Acta Radiologica,* 2003, vol. 44, 616-621
- IEC standard 61267. 1994